# EUROPEAN PATENT APPLICATION

(11) **EP 4 589 503 A1**
(43) Date of publication of application: **23.07.2025**
(21) Application number: 24212086.3
(22) Date of filing: 11.11.2024
(51) Int. Cl.: G06Q 10/067

(54) **METHOD TO CREATE HUMAN DIGITAL PROFILE AND RELATED APPLICATIONS**

(30) Priority: 18.01.2024 US 202418416390
(71) Applicant: Hitachi, Ltd., Tokyo 100-8280 (JP)
(72) Inventor: ZHOU, Quan, Tokyo, 100-8280 (JP); YUAN, Wei, Tokyo, 100-8280 (JP)
(74) Representative: MERH-IP Matias Erny Reichl Hoffmann Patentanwälte PartG mbB

(57) **Abstract**

A method for performing operation optimization through virtual simulation, the method comprising generating, by a processor, human digital profiles associated with a plurality of persons; performing, by the processor, virtual simulation using the human digital profiles as input to a first model; generating, by the processor, performance prediction as output from the first model; and performing operation optimization based on the performance prediction.

## Description

### BACKGROUND

### Field

The present disclosure is generally directed to a method and a system for performing operation optimization through virtual simulation.

### Related Art

In manufacturing and production processes that involve a certain level of human activities, quantitative information regarding the performance, efficiency, throughput, and quality of the operation are difficult to obtain and predict. However, such information, like detailed human capabilities for certain tasks, learning curve for new tasks, task time of each operation, quality of operations, is key information used in designing, monitoring, analyzing, and improving the manufacturing processes. When designing new production lines or modifying existing production lines, performance and throughput of each operation plays a key role in ensuring the proper flow of the manufacturing processes. The throughput and performance of machine and/or automated processes can be obtained relatively easily. However, performance and throughput of manual operations on the other hand, are relatively difficult to obtain.

In the related art, a method for generating performance and throughput through estimation is disclosed. However, information obtained through estimation performance can be rather inaccurate and application of which tends to lead to false results.

In the related art, a method for generating performance and throughput through physical measurement in a testing environment is disclosed. However, testing environment setup is not only time consuming but costly at the same time.

### SUMMARY

Aspects of the present disclosure involve an innovative method for performing operation optimization through virtual simulation. The method may include generating, by a processor, human digital profiles associated with a plurality of persons; performing, by the processor, virtual simulation using the human digital profiles as input to a first model; generating, by the processor, performance prediction as output from the first model; and performing operation optimization based on the performance prediction.

Aspects of the present disclosure involve an innovative non-transitory computer readable medium, storing instructions for performing operation optimization through virtual simulation. The instructions may include generating human digital profiles associated with a plurality of persons; performing virtual simulation using the human digital profiles as input to a first model; generating performance prediction as output from the first model; and performing operation optimization based on the performance prediction.

Aspects of the present disclosure involve an innovative server system for performing operation optimization through virtual simulation. The system may include generating, by a processor, human digital profiles associated with a plurality of persons; performing, by the processor, virtual simulation using the human digital profiles as input to a first model; generating, by the processor, performance prediction as output from the first model; and performing operation optimization based on the performance prediction.

Aspects of the present disclosure involve an innovative system for performing operation optimization through virtual simulation. The system may include means for generating human digital profiles associated with a plurality of persons; means for performing virtual simulation using the human digital profiles as input to a first model; means for generating performance prediction as output from the first model; and means for performing operation optimization based on the performance prediction.

### BRIEF DESCRIPTION OF DRAWINGS

A general architecture that implements the various features of the disclosure will now be described with reference to the drawings. The drawings and the associated descriptions are provided to illustrate example implementations of the disclosure and not to limit the scope of the disclosure. Throughout the drawings, reference numbers are reused to indicate correspondence between referenced elements.
FIG. 1 illustrates an example process flow 100 for generating a human digital profile, in accordance with an example implementation.
FIG. 2 illustrates an example process flow 200 of a human digital profile application, in accordance with an example implementation.
FIG. 3 illustrates an example system configuration 300, in accordance with an example implementation.
FIG. 4 illustrates a conventional line balancing process 400.
FIG. 5 illustrates an example line balancing process 500, in accordance with an example implementation.
FIG. 6 illustrates an example diagram 600 for performing automated detailed task information collection, in accordance with an example implementation.
FIG. 7 illustrates an example diagram 700 for performing production line design, in accordance with an example implementation.
FIG. 8 illustrates an example computing environment with an example computing device suitable for use in some example implementations.

### DETAILED DESCRIPTION

The following detailed description provides details of the figures and example implementations of the present application. Reference numerals and descriptions of redundant elements between figures are omitted for clarity. Terms used throughout the description are provided as examples and are not intended to be limiting. For example, the use of the term "automatic" may involve fully automatic or semi-automatic implementations involving user or administrator control over certain aspects of the implementation, depending on the desired implementation of one of the ordinary skills in the art practicing implementations of the present application. Selection can be conducted by a user through a user interface or other input means, or can be implemented through a desired algorithm. Example implementations as described herein can be utilized either singularly or in combination, and the functionality of the example implementations can be.

Example implementations provide a new method for measuring and modelling human capabilities in various categories and performing task/job simulations (virtual simulations) based on the measurements. Once the human characteristics are measured/modeled, a digital profile or digital twin of the human is then generated. Using this digital profile, performance of a worker/individual can be simulated for new operations (e.g., a task that the individual has never performed before, etc.). The digital profile can be used to map the skill level of a worker and provide information to help assign operations and/or trainings.

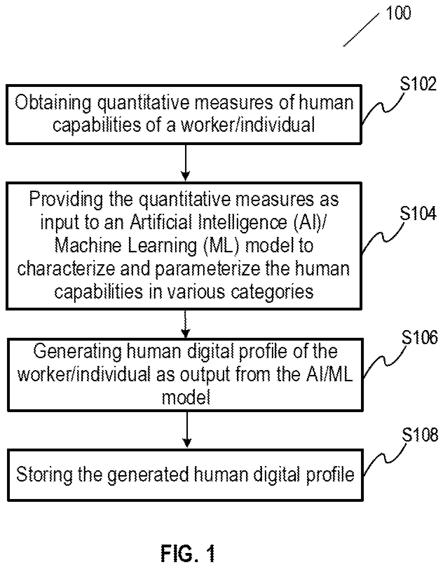

FIG. 1 illustrates an example process flow 100 for generating a human digital profile, in accordance with an example implementation. The preparation and characterization of the human digital profile is performed by the process flow 100. To characterize the capabilities of a worker/individual, a number of standardized tests need to be conducted. At step S102, quantitative measures of human capabilities of the worker/individual are obtained through a set of standardized tests. The standardized tests may involve categories such as, but not limited to, muscle strength, speed, balance, coordination, accuracy, agility, reaction time, senses, etc. To perform the standardized tests, multiple sensors such as fixed or wearable cameras, wearable sensors, health monitoring devices, etc., will be applied to obtain information/results (quantitative measures) such as pressure, force, angle, speed, time, completion status, quality of test, temperature, geometry, etc.

At step S104, the measurements are provided as input to an Artificial Intelligence (AI)/Machine Learning (ML) model to characterize and parameterize the human capabilities in various categories. The AI/ML model may include, but not limited to, convolutional neural network (CNN), recurrent neural network (RNN), deep RNN (DRNN), Q-learning network (QN), deep Q-learning network (DQN), linear regression, logistic regression, decision trees, K-Nearest Neighbors, etc. RNN may include long short-term memory (LSTM), etc.

The process then proceeds to step S106 where the human digital profile of the worker/individual is generated as output from the AI/ML model. The human digital profile may include quantitative measures of human capabilities in various categories. In some example implementations, each category may further include sub-categories. For example, the category "muscle strength" may have sub-categories for different muscle groups and performance for different type of strength-related tasks such as lifting, horizontal transfer, angle of arms/torso, etc. In alternate example implementations, a rule-based model may be utilized instead of the AI/ML model in performing characterization and parameterization of the human capabilities, as well as generation of the human digital profiles. At step S108, the generated human digital profiles are stored in a data storage, which can be local memory, centralized storage on the cloud, etc.

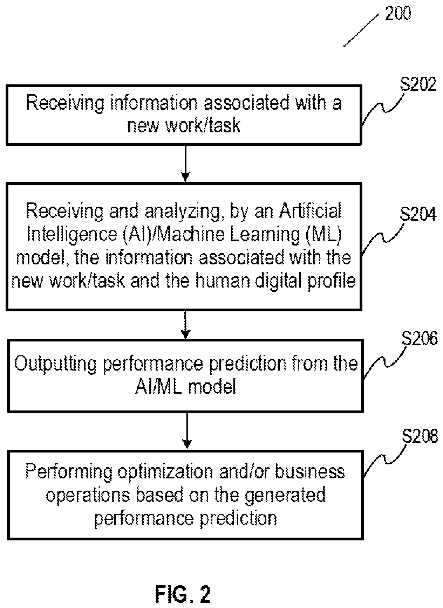

FIG. 2 illustrates an example process flow 200 of a human digital profile application, in accordance with an example implementation. The process begins at step S202 where information associated with a new work/task is received. Such information may include work/task description and quantitative work/task parameters. At step S204, an Artificial Intelligence (AI)/Machine Learning (ML) model receives and analyzes the information associated with the new work/task and the human digital profile as derived in FIG. 1. The AI/ML model is trained using historical human digital profiles and may include, but not limited to, convolutional neural network (CNN), recurrent neural network (RNN), deep RNN (DRNN), Q-learning network (QN), deep Q-learning network (DQN), linear regression, logistic regression, decision trees, K-Nearest Neighbors, etc. RNN may include long short-term memory (LSTM), etc. The AI/ML model analyzes the information associated with the new work/task (e.g., work content) and simulates (through virtual simulation) human performance using the information provided from the human digital profile.

At step S206, performance prediction is generated as output from the AI/ML model. The performance prediction may include information such as, but not limited to, ability of the worker/individual to perform the work (e.g., can or cannot), estimated training time to train for the work, estimated task completion time, estimated performance metrics (e.g., speed, quality, etc.), estimated fatigue level, work progression, etc. The prediction results can be stored in a data storage.

At step S208, the generated performance prediction is used in performing various optimization and business operations. Such operations may include, but not limited to, work cycle time estimation in manufacturing, production line performance simulation for line balancing/reconfiguration, performance simulation for production line design, worker skill mapping, training performance, video game design and customization, etc. In alternate example implementations, a rule-based model may be utilized instead of the AI/ML model in performing performance prediction.

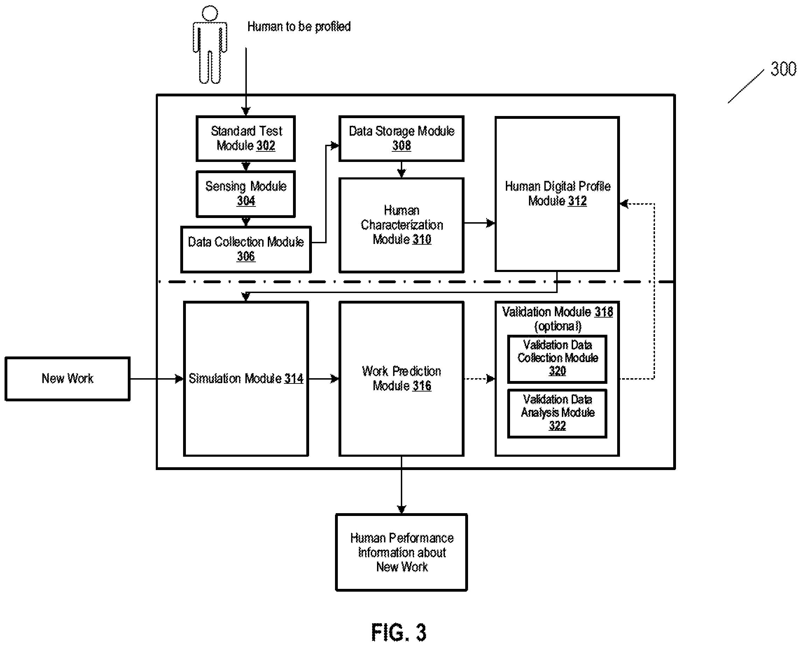

FIG. 3 illustrates an example system configuration 300, in accordance with an example implementation. As illustrated in FIG. 3, the system configuration 300 may include components such as a standard test module 302, a sensing module 304, a data collection module 306, a data storage module 308, a human characterization module 310, a human digital profile module 312, a simulation module 314, a work prediction module 316, etc. The standard test module 302, the sensing module 304, the data collection module 306, the data storage module 308, and the human characterization module 310 together form the human digital profile generation process described in FIG. 1. The simulation module 314 and the work prediction module 316 together form the human digital profile application process described in FIG. 2.

The standard test module 302 stores a set of standardized tests of various categories for a worker/individual to perform. The standard test module 302 may be physically or wirelessly connected to a number of sensors for quantifying human capabilities of the worker/individual in a number of categories. The sensing module 304 receives sensor data (raw data) generated from the sensors.

The data collection module 306 receives the sensor data (raw data) from the sensing module 304 and performs data preprocessing on the received sensor data. Data preprocessing may include cleaning, transforming, integrating the sensor data to prepare the sensor data for subsequent processing steps. The preprocessed data is then stored in the data storage module 308 wherein it will be retrieved for processing.

The human characterization module 310 analyzes the preprocessed data and generates the human digital profiles, which are then stored in the human digital profile module 312. In some example implementations, the data storage module 308 and the human digital profile module 312 are part of a data storage (not illustrated) to the system configuration 300. In some example implementations, one of at least the data storage module 308 or the human digital profile module 312 exists on a cloud storage.

The human digital profile application process is initiated through receipt of new work/task information at the simulation module 314. The simulation module 314 then performs work prediction by analyzing the received new work/task information and human digital profile as obtained from the human digital profile module 312. The generated work prediction is then outputted to a work prediction module 316, where it will be retrieved and further processed in various applications/uses.

In some example implementations, an optional validation module 318 may be included as part of the system configuration 300. The validation module 318 performs enhancement of the human digital profiles and may include two sub-modules, a validation data collection module 320 and a validation data analysis module 322. Data on physical performance of the work/task by a worker/individual can be collected using the validation data collection module 320 and used by the validation data analysis module 322 in performing data analysis. The validation data analysis module 322 compares the actual physical performance data on the work/task as performed by the worker against the predicted output from the work prediction module 316 to optimize/improve the associated human digital profile stored in the human digital profile module 312. The quantitative measures of human capabilities are updated based on the comparison, which can be used to further improve accuracies of results generated by the simulation module 314 and the work prediction module 316 in subsequent simulations.

### First embodiment - line balancing

Fluctuation of throughput is common across production lines in the automotive manufacturing process. Once such fluctuation is detected, the manufacturer then performs line balancing across the various stations of the production lines to address the fluctuation and improve throughput. Line balancing involves identification of slow/problematic stations and re-arranging operations between the different stations.

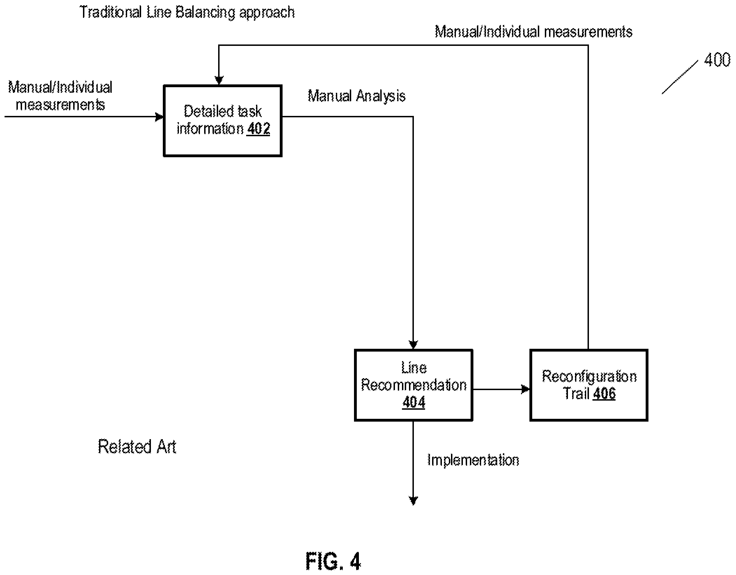

FIG. 4 illustrates a conventional line balancing process 400. Detailed task information 402 of various processes is typically measured manually at each work station and manually analyzed to identify issues in the production/manufacturing line. Such detailed task information 402 typically includes time spent on each task, target/standardized work descriptions, performance quality, etc. Based on the analysis, new line configurations/fine recommendation 404 are proposed by an experienced engineer and implemented at the shop floor. A reconfiguration trail 406 for documenting configuration changes is generated whenever line configurations are updated. Manual measurements are then performed to obtain updated detailed task information 402 in order to evaluate the modified line configurations. This balancing process may be repeated more than once to further improve production/manufacturing outcome. The process itself can be time-consuming and costly due to the labor involved as well as production down time from configuration implementation.

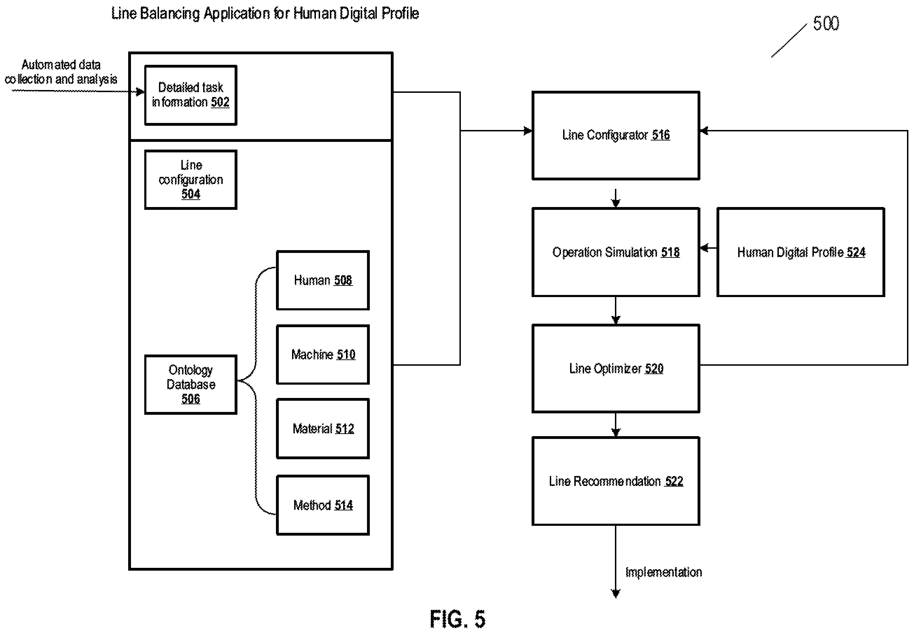

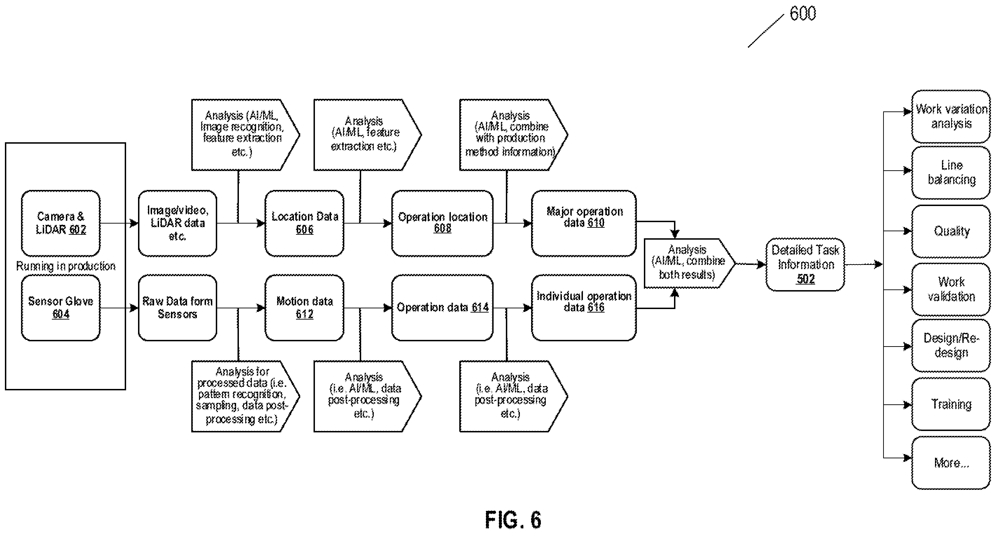

FIG. 5 illustrates an example line balancing process 500, in accordance with an example implementation. The line balancing process 500 provides higher efficiency, reduced cost, and minimized disturbance to the production/manufacturing process when compared to the conventional line balancing process. First, detailed task information 502 is generated by performing automated data collection and analysis, which will be described in more detail below in association with FIG. 6. A line configuration module 504 contains details of the configurations of the production/manufacturing line. The ontology database module 506 contains 4M ontology data (human data 508, machine data 510, material data 512, and method data 514). Together, the detailed task information 502, the line configuration information of the line configuration module 504, and the 4M ontology data of the ontology database module 506 are combined and inputted into a line configurator module 516.

The line configurator module 516 analyzes current performance and generates proposed configurations based on the ontology data along with physical constraints. The generated configurations are then sent as input to the operation simulation module 518. The operation simulation module 518 performs the simulation functions of the simulation module 314 of FIG. 3, and takes the configurations generated by the line configurator module 516 and digitized human capability data (human digital profiles 524 of relevant operators of the production line) from the human digital profile module 312 in performing simulations. Simulated performances of the configurations will then be outputted to the line optimizer 520, which compares the performance results and removes candidates based on the results (e.g., having a performance result that is below a performance threshold, etc.). The remaining candidates are then sent back to the line configurator module 516 with updated constraints and results for additional configuration updates. The processes of configuration generation, simulation and optimization may be repeated until one or a predetermined number of candidate configuration is generated as line recommendation 522. If a single candidate configuration is generated, then the configuration is implemented. If a predetermined number of candidates are generated, then the user selects a configuration to be implemented.

Based on the foregoing, performance of the line balancing process 500 does not require actual trial-and-error to be performed by workers/operators. In addition, utilization of the human digital profiles allows for generation of predictions and recommendations that are more accurate and reliable than conventional methods. For example, an operation that requires operator A to spend 10 seconds to perform may require operator B 15 seconds to perform. The human digital profiles identify such difference in operator capabilities and allow for prediction generation that considers such difference.

FIG. 6 illustrates an example diagram 600 for performing automated detailed task information collection, in accordance with an example implementation. During the production process, location data can be obtained from camera & Light Detection and Ranging (LiDAR) sensor 602, while other production data (e.g., operation errors, etc.) can be obtained using other sensor/sensing devices (i.e., a wearable sensing device) such as a sensor glove 604. The camera & LiDAR sensor 602 generates image/video from the camera and LiDAR data from the LiDAR sensor. Data analysis is then performed (e.g., AI/ML, image recognition, feature extraction, etc.) on the data to generate location data 606 of operator and/or object (e.g., identifier, timestamp, object orientation (x, y, z), etc.). The location data 606 is then analyzed (e.g., application of AI/ML, feature extraction, etc.) to identify operation locations 608 (e.g., tool rack, task area, installation site, primary operation areas, etc.). Major operation data 610 is then derived by analyzing the operation locations 608.

The sensor glove 604 generates other production data, which is then processed (e.g., pattern recognition, sampling, data post-processing, etc.) to generate motion data 612 (e.g., force, pressure, sound etc.). The motion data 612 is then analyzed (e.g., application of AI/ML, data post-processing, etc.) to generate detailed operation data 614 (e.g., pick up device/tool, drilling, installation tool, etc.). Detailed individual operation data 616 is then derived by analyzing the operation data 614.

The major operation data 610 and the detailed operation data 616 are then analyzed and combined to generate detailed task information 502. The collected detailed task information can be used to perform work variation analysis, line balancing, work quality verification, work validation, design/redesign of production lines, training, etc.

### Second embodiment - production line design and virtual commissioning

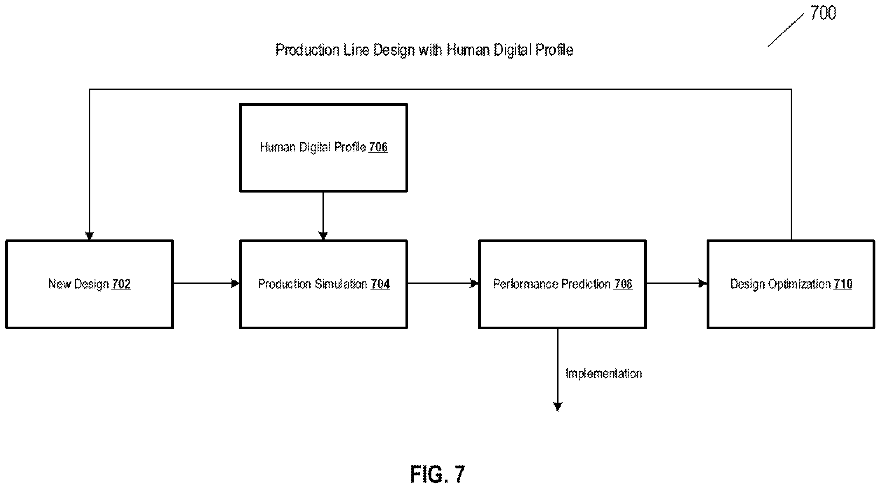

FIG. 7 illustrates an example diagram 700 for performing production line design, in accordance with an example implementation. A new production line design (new design 702) is proposed and provided to a production simulation module 704, which performs similar functions to the simulation module 314 of FIG. 3. In addition to the new design 702, the production simulation module 704 also receives human digital profile 706, which is generated by the human digital profile module 312, in performing production simulation. The production simulation module 704 then generates performance prediction 708, which is then used in determining whether to implement the new design 702 or generate additional recommendations using a design optimization module 710. If recommendations are generated by the design optimization module 710, then the recommendations are applied as updated new design 702, and additional simulations are performed based on the updated design.

### Third embodiment - game design

Human digital profiles may also be used in the design/creation of virtual characters in games or any metaverse-based software. Player can take part in a set or sub-set of tests performed by the standard test module 302 of FIG. 3 in generating their digital profiles. The human digital profiles can then be utilized in enhancing in-game reality representation of players and their capabilities.

### Fourth embodiment - skill mapping & training

The generation of the human digital profile naturally provides a benchmark of the skills and capabilities of the operators. Additional insights can be generated to recommend training materials as well as track training progress.

The foregoing example implementations may have various benefits and advantages. For example, an unconventional way of improving product line configurations through generation of human digital profiles in mapping accurate skill levels of workers and performing virtual simulations based on the human digital profiles to optimize line configurations. Measurements derived from various sensor and tests are provided as input to an AI/ML model in generating human digital profiles that uniquely characterize and parametrize capabilities of employees/workers that could not be achieved under related art. Implementations of the human digital profiles in trainings and simulations help quantify worker/employee performance, reduce cost, and minimize disturbance to actual production/manufacturing processes.

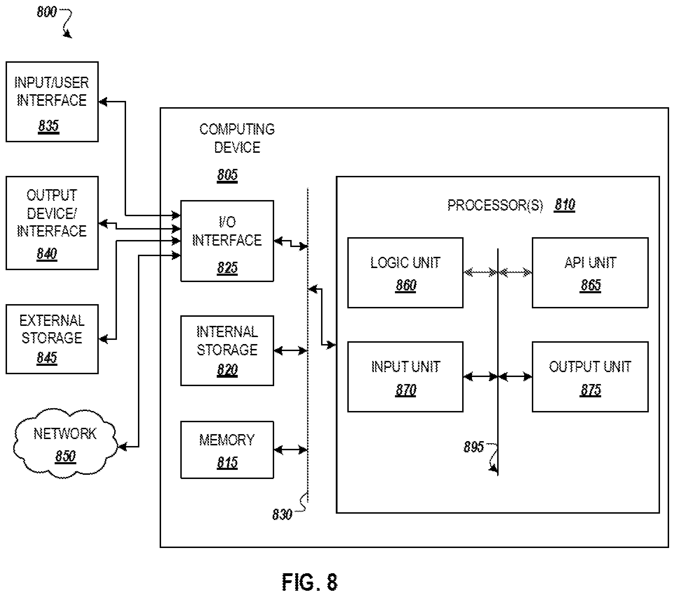

FIG. 8 illustrates an example computing environment with an example computing device suitable for use in some example implementations. Computing device 805 in computing environment 800 can include one or more processing units, cores, or processor(s) 810, memory 815 (e.g., RAM, ROM, and/or the like), internal storage 820 (e.g., magnetic, optical, solid-state storage, and/or organic), and/or I/O interface 825, any of which can be coupled on a communication mechanism or bus 830 for communicating information or embedded in the computing device 805. I/O interface 825 is also configured to receive images from cameras or provide images to projectors or displays, depending on the desired implementation.

Computing device 805 can be communicatively coupled to input/user interface 835 and output device/interface 840. Either one or both of the input/user interface 835 and output device/interface 840 can be a wired or wireless interface and can be detachable. Input/user interface 835 may include any device, component, sensor, or interface, physical or virtual, that can be used to provide input (e.g., buttons, touch-screen interface, keyboard, a pointing/cursor control, microphone, camera, braille, motion sensor, accelerometer, optical reader, and/or the like). Output device/interface 840 may include a display, television, monitor, printer, speaker, braille, or the like. In some example implementations, input/user interface 835 and output device/interface 840 can be embedded with or physically coupled to the computing device 805. In other example implementations, other computing devices may function as or provide the functions of input/user interface 835 and output device/interface 840 for a computing device 805.

Examples of computing device 805 may include, but are not limited to, highly mobile devices (e.g., smartphones, devices in vehicles and other machines, devices carried by humans and animals, and the like), mobile devices (e.g., tablets, notebooks, laptops, personal computers, portable televisions, radios, and the like), and devices not designed for mobility (e.g., desktop computers, other computers, information kiosks, televisions with one or more processors embedded therein and/or coupled thereto, radios, and the like).

Computing device 805 can be communicatively coupled (e.g., via I/O interface 825) to external storage 845 and network 850 for communicating with any number of networked components, devices, and systems, including one or more computing devices of the same or different configuration. Computing device 805 or any connected computing device can be functioning as, providing services of, or referred to as, a server, client, thin server, general machine, special-purpose machine, or another label.

I/O interface 825 can include, but is not limited to, wired and/or wireless interfaces using any communication or I/O protocols or standards (e.g., Ethernet, 802.11x, Universal System Bus, WiMax, modem, a cellular network protocol, and the like) for communicating information to and/or from at least all the connected components, devices, and network in computing environment 800. Network 850 can be any network or combination of networks (e.g., the Internet, local area network, wide area network, a telephonic network, a cellular network, satellite network, and the like).

Computing device 805 can use and/or communicate using computer-usable or computer-readable media, including transitory media and non-transitory media. Transitory media include transmission media (e.g., metal cables, fiber optics), signals, carrier waves, and the like. Non-transitory media include magnetic media (e.g., disks and tapes), optical media (e.g., CD ROM, digital video disks, Blu-ray disks), solid-state media (e.g., RAM, ROM, flash memory, solid-state storage), and other non-volatile storage or memory.

Computing device 805 can be used to implement techniques, methods, applications, processes, or computer-executable instructions in some example computing environments. Computer-executable instructions can be retrieved from transitory media, and stored on and retrieved from non-transitory media. The executable instructions can originate from one or more of any programming, scripting, and machine languages (e.g., C, C++, C#, Java, Visual Basic, Python, Perl, JavaScript, and others).

Processor(s) 810 can execute under any operating system (OS) (not shown), in a native or virtual environment. One or more applications can be deployed that include logic unit 860, application programming interface (API) unit 865, input unit 870, output unit 875, and inter-unit communication mechanism 895 for the different units to communicate with each other, with the OS, and with other applications (not shown). The described units and elements can be varied in design, function, configuration, or implementation and are not limited to the descriptions provided. Processor(s) 810 can be in the form of hardware processors such as central processing units (CPUs) or in a combination of hardware and software units.

In some example implementations, when information or an execution instruction is received by API unit 865, it may be communicated to one or more other units (e.g., logic unit 860, input unit 870, output unit 875). In some instances, logic unit 860 may be configured to control the information flow among the units and direct the services provided by API unit 865, the input unit 870, and the output unit 875 in some example implementations described above. For example, the flow of one or more processes or implementations may be controlled by logic unit 860 alone or in conjunction with API unit 865. The input unit 870 may be configured to obtain input for the calculations described in the example implementations, and the output unit 875 may be configured to provide an output based on the calculations described in example implementations.

Processor(s) 810 can be configured to generate human digital profiles associated with a plurality of persons as shown in FIGS. 1-3. The processor(s) 810 may also be configured to perform virtual simulation using the human digital profiles as input to a first model as shown in FIGS. 1-3. The processor(s) 810 may also be configured to generate performance prediction as output from the first model as shown in FIGS. 1-3. The processor(s) 810 may also be configured to perform operation optimization based on the performance prediction as shown in FIGS. 1-3.

The processor(s) 810 may also be configured to perform data validation on the human digital profiles based on the performance prediction as shown in FIG. 3. The processor(s) 810 may also be configured to update the human digital profiles based on a result of the data validation as shown in FIG. 3. The processor(s) 810 may also be configured to generate a line configuration as shown in FIG. 7. The processor(s) 810 may also be configured to receive task information, production line configuration information, and ontology information as shown in FIG. 5.

Some portions of the detailed description are presented in terms of algorithms and symbolic representations of operations within a computer. These algorithmic descriptions and symbolic representations are the means used by those skilled in the data processing arts to convey the essence of their innovations to others skilled in the art. An algorithm is a series of defined steps leading to a desired end state or result. In example implementations, the steps carried out require physical manipulations of tangible quantities for achieving a tangible result.

Unless specifically stated otherwise, as apparent from the discussion, it is appreciated that throughout the description, discussions utilizing terms such as "processing," "computing," "calculating," "determining," "displaying," or the like, can include the actions and processes of a computer system or other information processing device that manipulates and transforms data represented as physical (electronic) quantities within the computer system's registers and memories into other data similarly represented as physical quantities within the computer system's memories or registers or other information storage, transmission or display devices.

Example implementations may also relate to an apparatus for performing the operations herein. This apparatus may be specially constructed for the required purposes, or it may include one or more general-purpose computers selectively activated or reconfigured by one or more computer programs. Such computer programs may be stored in a computer readable medium, such as a computer readable storage medium or a computer readable signal medium. A computer readable storage medium may involve tangible mediums such as, but not limited to, optical disks, magnetic disks, read-only memories, random access memories, solid-state devices and drives, or any other types of tangible or non-transitory media suitable for storing electronic information. A computer readable signal medium may include mediums such as carrier waves. The algorithms and displays presented herein are not inherently related to any particular computer or other apparatus. Computer programs can involve pure software implementations that involve instructions that perform the operations of the desired implementation.

Various general-purpose systems may be used with programs and modules in accordance with the examples herein, or it may prove convenient to construct a more specialized apparatus to perform desired method steps. In addition, the example implementations are not described with reference to any particular programming language. It will be appreciated that a variety of programming languages may be used to implement the teachings of the example implementations as described herein. The instructions of the programming language(s) may be executed by one or more processing devices, e.g., central processing units (CPUs), processors, or controllers.

As is known in the art, the operations described above can be performed by hardware, software, or some combination of software and hardware. Various aspects of the example implementations may be implemented using circuits and logic devices (hardware), while other aspects may be implemented using instructions stored on a machine-readable medium (software), which if executed by a processor, would cause the processor to perform a method to carry out implementations of the present application. Further, some example implementations of the present application may be performed solely in hardware, whereas other example implementations may be performed solely in software. Moreover, the various functions described can be performed in a single unit, or can be spread across a number of components in any number of ways. When performed by software, the methods may be executed by a processor, such as a general-purpose computer, based on instructions stored on a computer readable medium. If desired, the instructions can be stored in the medium in a compressed and/or encrypted format.

Moreover, other implementations of the present application will be apparent to those skilled in the art from consideration of the specification and practice of the teachings of the present application. Various aspects and/or components of the described example implementations may be used singly or in any combination. It is intended that the specification and example implementations be considered as examples only, with the true scope and spirit of the present application being indicated by the following claims.

## Claims

1. A method for performing operation optimization through virtual simulation, the method comprising:
generating, by a processor, human digital profiles associated with a plurality of persons;
performing, by the processor, virtual simulation using the human digital profiles as input to a first model;
generating, by the processor, performance prediction as output from the first model; and
performing operation optimization based on the performance prediction.

2. The method of claim 1, further comprising:
performing, by the processor, data validation on the human digital profiles based on the performance prediction,
wherein the processor is configured to perform data validation by comparing the performance prediction with actual performance data of actual work performed by the plurality of persons.

3. The method of claim 2, further comprising:
updating, by the processor, the human digital profiles based on a result of the data validation.

4. The method of claim 1, further comprising:
generating a line configuration,
wherein the first model generates the performance prediction by using the line configuration and the human digital profiles as input, and
wherein performing the operation optimization comprises optimizing the line configuration based on the performance prediction to generate and implement optimized line configuration.

5. The method of claim 4, further comprising:
receiving task information, production line configuration information, and ontology information,
wherein the line configuration is generated based on the task information, the production line configuration information, and the ontology information.

6. The method of claim 1, wherein the processor is configured to generate the human digital profiles by:
obtaining quantitative measures of the plurality of persons using a plurality of sensors; and
using the quantitative measures of the plurality of persons as input to a second model to generate the human digital profiles.

7. The method of claim 1, wherein the human digital profiles comprise quantitative measures of human capability in a plurality of categories.

8. The method of claim 1, wherein the first model is trained using historical human digital profiles.

9. The method of claim 1, further comprising:
using the human digital profiles to monitor training progression of the plurality of persons; and
providing training recommendations based on monitored training progression.

10. The method of claim 1, further comprising:
using the human digital profiles to design virtual characters for enhanced reality representation.

11. A system for performing operation optimization through virtual simulation, the system comprising:
a plurality of sensors; and
a processor in communication with the plurality of sensors, the processor is configured to:
generate human digital profiles associated with a plurality of persons by using the plurality of sensors;
perform virtual simulation using the human digital profiles as input to a first model;
generate performance prediction as output from the first model; and
perform operation optimization based on the performance prediction.

12. The system of claim 11, wherein the processor is further configured to:
perform data validation on the human digital profiles based on the performance prediction,
wherein the processor is configured to perform data validation by comparing the performance prediction with actual performance data of actual work performed by the plurality of persons.

13. The system of claim 12, wherein the processor is further configured to:
update the human digital profiles based on a result of the data validation.

14. The system of claim 11, wherein the processor is further configured to:
generating a line configuration,
wherein the first model generates the performance prediction by using the line configuration and the human digital profiles as input, and
wherein perform the operation optimization comprises optimizing the line configuration based on the performance prediction to generate and implement optimized line configuration.

15. The system of claim 14, wherein the processor is further configured to:
receive task information, production line configuration information, and ontology information,
wherein the line configuration is generated based on the task information, the production line configuration information, and the ontology information.

16. The system of claim 11, wherein the processor is configured to generate the human digital profiles by:
obtaining quantitative measures of the plurality of persons using the plurality of sensors; and
using the quantitative measures of the plurality of persons as input to a second model to generate the human digital profiles.

17. The system of claim 11, wherein the human digital profiles comprise quantitative measures of human capability in a plurality of categories.

18. The system of claim 11, wherein the first model is trained using historical human digital profiles.

19. The system of claim 11, wherein the processor is further configured to:
use the human digital profiles to monitor training progression of the plurality of persons; and
provide training recommendations based on monitored training progression.

20. The system of claim 11, wherein the processor is further configured to:
use the human digital profiles to design virtual characters for enhanced reality representation.
